# EUROPEAN PATENT APPLICATION

(11) **EP 1 744 169 A2**
(43) Date of publication of application: **17.01.2007**
(21) Application number: 06253570.3
(22) Date of filing: 07.07.2006
(51) Int. Cl.: G01R 31/34

(54) **Means of detecting faults in alternators**

(30) Priority: 12.07.2005 US 178294
(71) Applicant: Pratt & Whitney Canada Corp., Longueuil QC J4G 1A1 (CA)
(72) Inventor: Smith, Michael Paul, Montreal Ouest Quebec H4X 1Z3 (CA); Matthews, Peter John David, Oakville Ontario L6M 1H8 (CA)
(74) Representative: Leckey, David Herbert

(57) **Abstract**

A method and apparatus is disclosed for detecting one or more faults in a multi-phase alternator (40), wherein a phase sensing unit (44), comprising a star wound resistor assembly, senses each phase of the alternator (40) and provides an indirect phase measure; further wherein a comparing unit (46), comprising an op amp (48), receives and compares each of the corresponding phase measures with a reference to provide a comparison result and wherein a fault detection unit (49) receiving the comparison result and providing a fault condition signal in the case of a fault.

## Description

### TECHNICAL FIELD

This invention relates to the field of electronics. More precisely this invention pertains to detecting faults in multi-phase alternators.

### BACKGROUND OF THE INVENTION

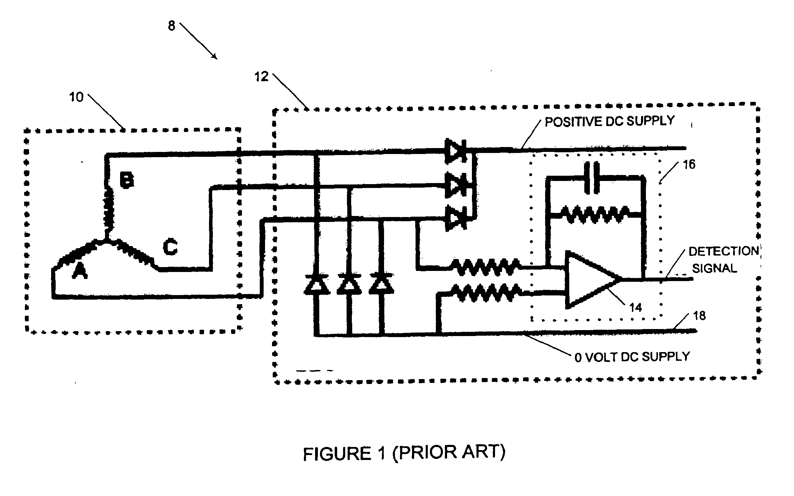

Now referring to Fig. 1, there is shown a prior art embodiment of an apparatus 12 for detecting a fault in a multi-phase alternator 10. In this embodiment, the multi-phase alternator 10 comprises 3 phases A, B and C which are star wound.

The apparatus 12 comprises a comparing unit 16 comprising an operational amplifier 14. A comparison is performed between a reference signal 18 and a voltage signal provided by a given phase, in this case phase A.

In the case where a fault occurs at phase A, for instance, if phase A goes open circuit, the fault will be detected as the result of the comparison with the reference signal 18 will change. Unfortunately, if a fault occurs at phases B or C, it will remain undetected therefore creating potential electrical hazards.

There is a need for a method and apparatus that will overcome the above-identified drawbacks.

### SUMMARY OF THE INVENTION

In one of its aspects, the present invention provides a method and apparatus for detecting one or more faults on a multi-phase alternator.

According to an embodiment of the invention, there is provided a method for detecting a fault in a multi-phase alternator. The method comprises providing an indirect measure of at least two of the phases of the multi-phase alternator; comparing the indirect measure of the phases with a reference; and detecting a fault condition using the comparison.

According to another embodiment of the invention, there is provided an apparatus for detecting a fault on a multi-phase alternator. The apparatus comprises a phase sensing unit for monitoring the multi-phase alternator and for reading a signal that indirectly measures at least two of the phases, thereby providing an indirect phase measure signal; and a comparing unit for receiving and comparing the indirect phase measure signal with a given reference signal to provide a comparison result signal indicative of the comparison; the comparison being used to detect the fault.

According to another embodiment of the invention, the apparatus for detecting a fault on a multi-phase alternator comprises a phase sensing unit having a star wound resistor assembly comprising a plurality of resistors, each resistor being connected, at one end, to a corresponding phase of the multi-phase alternator and, at the other end, a common star point from which is read an indirect phase measure signal; and a comparing unit having an operational amplifier receiving the indirect phase measure signal and a reference signal and providing therefrom a comparison result signal indicative of the comparison; the comparison being used to detect the fault.

Further details of these and other aspects of the present invention will be apparent from the detailed description and Figures included below.

### BRIEF DESCRIPTION OF THE DRAWINGS

Reference is now made to the accompanying Figures depicting aspects of the present invention, in which:
Fig. 1. is an electronic schematics showing a prior art embodiment of an apparatus for detecting a fault on a single phase in a multi-phase alternator;
Fig. 2. is a block diagram showing an embodiment of an apparatus for detecting one or more faults in a multi-phase alternator;
Fig. 3. is a flowchart showing the steps for detection of a fault on a phase of a multi-phase alternator is detected according to the invention; and
Fig. 4 is an electronic schematic showing a second embodiment of an apparatus for detecting one or more faults in a multi-phase alternator.

It will be noted that throughout the appended drawings, like features are identified by like reference numerals.

### DETAILED DESCRIPTION OF THE PREFERRED EMBODIMENT

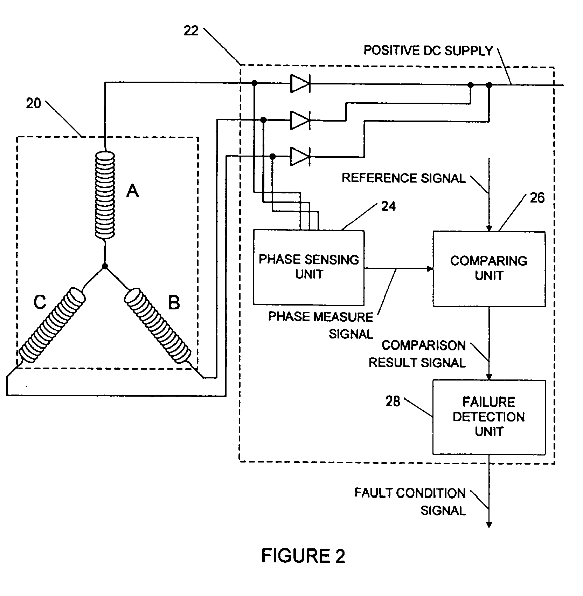

Now referring to Fig. 2, there is shown an embodiment of an apparatus 22 for detecting one or more faults in a multi-phase alternator 20 comprising 3 phases A, B and C which are star wound.

The apparatus 22 for detecting one or more faults in a multi-phase alternator 20 comprises a phase sensing unit 24, a comparing unit 26 and a fault detection unit 28. It is to be note that the apparatus 22 may be incorporated in a Electronic Engine Controller (EEC)

More precisely, the phase sensing unit 24 receives a first voltage signal, a second voltage signal and a third voltage signal provided respectively by phase A, phase B and phase C. Using the voltage signals from phases A, B, and C, the phase sensing unit 24 provides a phase measure signal.

The comparing unit 26 receives the phase measure signal provided by the phase sensing unit 24 and a reference signal and performs a comparison to provide a comparison result signal.

The fault detection unit 28 receives the comparison result signal and provides a fault detection signal when a fault is detected.

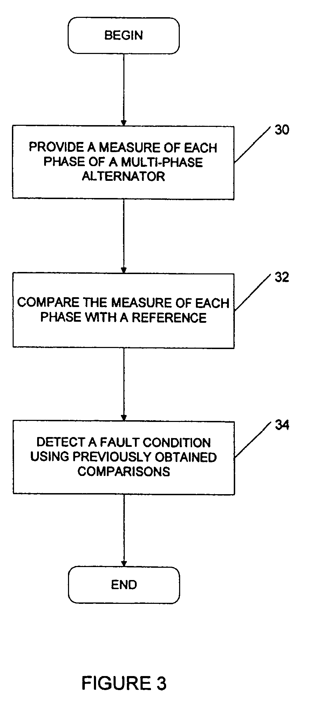

Now referring to Fig. 3, there is shown how the apparatus 22 for detecting one or more faults in a multi-phase alternator operates.

According to step 30, a measure of each phase of the multi-phase alternator is provided. Referring back to Fig. 2, the measure of each phase of the multi-phase alternator is provided using the phase sensing unit 24. The phase measure signal comprises an indication of the measure of each phase of the multi-phase alternator. If there are no faults present then the balanced nature of the output voltage of a multi-phase alternator will present a phase sensing signal with a certain relationship to the reference signal. Whereas if there is a fault present then the unbalanced nature of the alternator output voltage will disturb this relationship in a detectable way.

Referring to step 32 of Fig. 3, a comparison is performed between the measure of each phase and a reference using the comparing unit 26 of Fig. 2. In fact, the comparing unit 26 receives the phase measure signal indicative of the measure of each phase of the multi-phase alternator and compares it with a reference signal. The comparing unit 26 provides a comparison result signal indicative of the result of the comparison.

Referring to step 34 of Fig. 3, a fault condition is determined using the comparison result signal. The skilled addressee will appreciate that when a fault occurs, the comparison result signal will have a pattern indicative of the fault.

Referring back to Fig. 2, the detection of the fault is performed by the fault detection unit 28 using the comparison result signal. In fact, the comparison result signal evolves over time according to a predefined pattern depending on various parameters such as rotation speed of the alternator, specifications of the phase element, etc., which is therefore expected when the multi-phase alternator operates in a normal mode. As soon as a fault occurs, the comparison result signal evolves over time according to another pattern which is indicative of the fault at any given phase of the multi-phase alternator.

The fault detection unit 28 provides a fault detection signal. It will be appreciated that in one embodiment, the fault detection signal is only representative of a fault occurring without any further details.

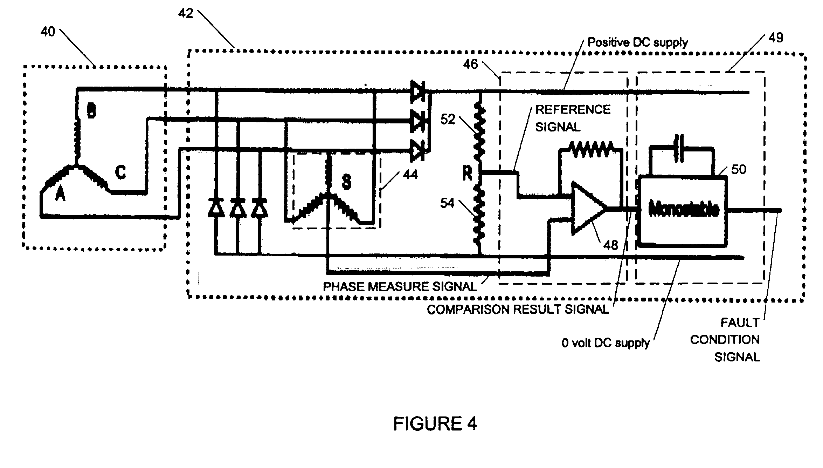

Now referring to Fig. 4, there is shown an embodiment of an apparatus 42 for detecting one or more faults on a phase in a multi-phase alternator according to one embodiment of the invention.

The apparatus 42 comprises a phase sensing unit 44, a comparing unit 46, and a fault detection unit 49.

The phase sensing unit 44 comprises three resistors (i.e., a star wound resistor assembly) which create an artificial star point S. Each resistor is connected to a phase A, B and C of the multi-phase alternator. The value of the resistor is chosen based on at least the fact that it must be between a maximum which is low by comparison with the current drawn by the comparing unit, and a minimum which presents a trivial load on the alternator. In one embodiment, each resistor has a value of 1 kohms. The star point S therefore provides a phase measure signal which comprises a measure of the voltage value of each phase A, B and C. In an embodiment, with no faults present, this voltage is approximately at the potential of the "0 volt DC supply". When there is an open circuit fault on (say phase A, then this voltage is the mean of phases B and C.

The comparing unit 46 receives the phase measure signal. The comparing unit 46 comprises an operational amplifier 48. The operational amplifier 48 receives the phase measure signal as well as a reference signal which is simply a given fraction between the positive DC supply and the 0 volt DC line obtained using resistances 52 and 54. The operational amplifier 48 compares the received phase measure signal indicative of the measure of each phase as with the reference signal and thereby provides the comparison result signal to the monostable circuit 50 of the failure detection unit 49. Using the comparison result signal, the monostable circuit 50 provides a fault condition signal indicative of a fault condition.

While illustrated in the block diagrams as groups of discrete components communicating with each other via distinct data signal connections, it will be understood by those skilled in the art that the preferred embodiments may be provided by a combination of hardware and software components, with some components being implemented by a given function or operation of a hardware or software system, and many of the data paths illustrated being implemented by data communication within a computer application or operating system. The structure illustrated is thus provided for efficiency of teaching the present

### preferred embodiment.

The above description is meant to be exemplary only, and one skilled in the art will recognize that further changes may be made to the embodiments described without departing from the scope of the invention disclosed. Still other modifications will be apparent to those skilled in the art, in light of a review of this disclosure, and such modifications are intended to fall within the appended claims.

## Claims

1. A method for detecting a fault in a multi-phase alternator (20), said method comprising:
providing an indirect measure of at least two of said phases (B,C) of said multi-phase alternator (20);
comparing the indirect measure of the phases (B,C) with a reference; and
detecting a fault condition using said comparison.

2. The method of claim 1, wherein said detecting a fault condition occurs when said comparison meets a given criteria.

3. The method of claim 2, further comprising providing said reference.

4. The method of claim 3, wherein said providing said reference comprises calculating a ratio between a positive DC supply of said multi-phase alternator and a 0 volt DC line to obtain said reference.

5. The method of any preceding claim, wherein said providing an indirect measure comprises taking said indirect measure at a connection point that is common to some of the phases.

6. The method of claim 6, wherein said providing an indirect measure further comprises connecting a resistor between at least two of the phases and said connection point.

7. The method of any of claims 1 to 4, wherein said providing an indirect measure comprises taking said indirect measure at a connection point that is common to all the phases.

8. The method of claim 7, wherein said providing an indirect measure further comprises connecting a resistor between each of the phases and said connection point.

9. An apparatus (22,42) for detecting a fault in a multi-phase alternator (20,40), said apparatus comprising:
a phase sensing unit (24,44) for monitoring said multi-phase alternator and for reading a signal that indirectly measures at least two of said phases, thereby providing an indirect phase measure signal; and
a comparing unit (26,46) for receiving and comparing said indirect phase measure signal with a given reference signal to provide a comparison result signal indicative of said comparison;
said comparison being used to detect said fault.

10. The apparatus of claim 9, further comprising a fault detection unit (28,49) for receiving and using said comparison result signal for providing a fault condition signal indicative of a fault condition.

11. The apparatus of claim 10, wherein said phase sensing unit (44) comprises a star wound resistor assembly comprising a plurality of resistors, each resistor being connected to a corresponding phase of said multi-phase alternator (40), said star wound resistor assembly comprising a star point (S) to which each resistor is connected and from which is performed said sampling of said indirect phase measure signal.

12. The apparatus of claim 11, wherein said comparing unit (46) comprises an operational amplifier (48) receiving said indirect phase measure signal and a reference signal and providing said comparison result signal.

13. The apparatus of claim 12, wherein said fault detection unit (49) comprises a monostable circuit (50) receiving and using said comparison result signal to provide said fault condition signal.

14. The apparatus of claim 12 or 13, wherein said given reference comprises a ratio between a positive DC supply of said multi-phase alternator and a 0 volt DC line.

15. An apparatus (42) for detecting one or more faults in a multi-phase alternator (40), said apparatus comprising:
a phase sensing unit (44) having a star wound resistor assembly comprising a plurality of resistors, each resistor being connected, at one end, to a corresponding phase of said multi-phase alternator (40) and, at the other end, a common star point (S) from which is read an indirect phase measure signal; and
a comparing unit (46) having an operational amplifier (48) receiving said indirect phase measure signal and a reference signal and providing therefrom a comparison result signal indicative of said comparison;
said comparison being used to detect said fault.

16. The apparatus of claim 15, wherein said comparing unit further comprises a monostable circuit (50) receiving and using said comparison result signal to provide a fault condition signal.
